Europäisches Patentamt

European Patent Office

Office européen des brevets

(19)

(11) EP 0 891 656 B1

(12) FASCICULE DE BREVET EUROPEEN

(45) Date de publication et mention
de la délivrance du brevet:
**15.09.1999 Bulletin 1999/37**

(21) Numéro de dépôt: **97919481.8**

(22) Date de dépôt: **03.04.1997**

(51) Int Cl.$^6$: **H03M 13/12**

(86) Numéro de dépôt international:
**PCT/FR97/00607**

(87) Numéro de publication internationale:
**WO 97/38495 (16.10.1997 Gazette 1997/44)**

(54) **PROCEDE ET DISPOSITIF DE CODAGE CONVOLUTIF DE BLOCS DE DONNEES, ET PROCEDE ET DISPOSITIF DE DECODAGE CORRESPONDANTS**

VERFAHREN UND VORRICHTUNG ZUR FALTUNGSKODIERUNG UND -DEKODIERUNG VON DATENBLÖCKEN

DATA BLOCK CONVOLUTIONAL CODING DEVICE AND METHOD, AND CORRESPONDING DECODING METHOD AND DEVICE

(84) Etats contractants désignés:
**DE ES FI GB IT SE**

(30) Priorité: **03.04.1996 FR 9604485**

(43) Date de publication de la demande:
**20.01.1999 Bulletin 1999/03**

(73) Titulaires:
• **FRANCE TELECOM**
  **75015 Paris (FR)**
• **TELEDIFFUSION DE FRANCE**
  **75932 Paris Cédex 15 (FR)**

(72) Inventeurs:
• **BERROU, Claude**
  **F-29280 Locmaria-Plouzane (FR)**
• **JEZEQUEL, Michel**
  **F-29200 Brest (FR)**

(74) Mandataire: **Vidon, Patrice**
  **Cabinet Patrice Vidon,**
  **Immeuble Germanium,**
  **80, Avenue des Buttes-de-Coesmes**
  **35700 Rennes (FR)**

(56) Documents cités:
  **US-A- 4 293 951**

• **IEEE TRANSACTIONS ON COMMUNICATIONS, AUG. 1989, USA, vol. 37, no. 8, Août 1989, ISSN 0090-6778, pages 875-879, XP000047627 WANG Q ET AL: "An efficient maximum likelihood decoding algorithm for generalized tail biting convolutional codes including quasicyclic codes"**

## Description

Le domaine de l'invention est celui du codage de données numériques, et en particulier de données source organisées en blocs de données, ou messages, indépendants les uns des autres, et devant donc être codés, et décodés, unitairement.

Plus précisément, l'invention concerne un procédé et un dispositif de codage correcteur d'erreurs, de type convolutif, adapté aux contraintes posées par la transmission de messages, et notamment de messages courts (par exemple de l'ordre de quelques dizaines ou quelques centaines de bits). L'invention concerne également un procédé et un dispositif de décodage, adapté au procédé de codage de l'invention.

L'invention trouve des applications dans tous les cas où il est nécessaire de transmettre des informations numériques avec un certain degré de fiabilité. Un domaine d'application privilégié de l'invention est celui de la transmission numérique sur des canaux très bruités. A titre d'exemple, l'invention peut être mise en oeuvre pour l'émission et la réception de signaux par l'intermédiaire de satellites. Notamment, l'invention peut être utilisée pour les communications avec les satellites à défilement. En effet, dans les systèmes mettant en oeuvre de tels satellites, les communications ne peuvent avoir lieu que par salves très courtes de données, aux moments où les satellites se trouve dans l'axe de l'antenne terrestre.

L'invention peut également avantageusement être utilisée pour les transmissions spatiales vers, ou entre les vaisseaux spatiaux et/ou des ondes spatiales, et dans tous les cas où la fiabilité du décodage est critique.

Plus généralement, l'invention peut toutefois s'appliquer de la même façon à tout type de transmission, par voie hertzienne ou par câble. Notamment, elle peut être utilisée pour les systèmes de radiocommunication numérique, tel que le GSM. Une autre application possible est la transmission de données sur des réseaux informatiques, et notamment le réseau INTERNET.

Tout signal numérique, quel qu'en soit l'origine, peut être codé et décodé selon l'invention, dès lors qu'il est organisé en blocs de taille fixe.

On sait que les codeurs convolutifs sont particulièrement efficaces, en terme de qualité de correction d'erreurs. On rappelle que, de façon générale, les codes convolutifs sont des codes associant à chaque donnée source à coder au moins une donnée codée, obtenue par sommation modulo 2 de cette donnée source avec au moins une des données source précédentes. Ainsi, chaque symbole codé est une combinaison linéaire de la donnée source à coder et des données source précédentes prises en compte.

Dans le décodeur, les données d'origine sont le plus souvent reconstruites à l'aide d'un algorithme à maximum de vraisemblance, et par exemple l'algorithme de Viterbi, dont les décisions peuvent éventuellement être pondérées. Cet algorithme prend en compte une séquence de symboles codés reçus, pour fournir une estimation de chaque donnée codée à l'émission, en déterminant la séquence source correspondant le plus probablement à la séquence reçue.

Parmi les codes convolutifs, on connaît sous le nom de "turbo-code", une technique très avantageuse. Les turbo-codes sont notamment décrits dans le brevet européen EP-A-511 141 ayant pour titre "procédé de codage correcteur d'erreurs à au moins deux codages convolutifs systématiques en parallèle, procédé de décodage itératif, module de décodage et décodeur correspondants", et dans l'article de C. Berrou, A. Glavieux and P. Thitimajshima, "Near Shannon limit error-correcting coding and decoding : "turbo-codes", Proc. of IEEE ICC '93, Geneva, pp. 1064-1070, May 1993.

Les turbo-codes sont des codes correcteurs binaires quasi-optimaux, en ce sens de leur pouvoir de correction est proche de la limite théorique prédite par Shannon en 1947.

Un turbo-code est construit à partir d'une concaténation parallèle de codes convolutifs systématiques récursifs (CSR) couplés par un entrelacement non uniforme.

Le décodage, qui ne peut être global compte tenu du très grand nombre d'états à considérer, fait appel à un processus itératif s'appuyant sur le concept d'information extrinsèque. La complexité de décodage est compatible avec les densités d'intégration sur silicium actuelles, et cette technique a d'ores et déjà donné lieu à des réalisations matérielles.

Les turbo-codes et plus généralement le codage convolutif sont bien appropriés à la transmission de messages longs, par exemple à la diffusion continue.

En revanche, lorsqu'il s'agit de protéger des messages courts, de longueur N, se pose le problème de la connaissance de l'état final du codeur après que les N bits lui aient été appliqués. Si cette information n'est pas fournie, ou si l'état du codeur n'est pas forcé à une valeur connue par l'application de bits supplémentaires ("tail bits"), le décodeur, par exemple un décodeur de Viterbi, perd de son pouvoir de correction.

Par ailleurs, si le code n'est pas "fermé", il est impossible de mettre en oeuvre un décodage séquentiel s'appuyant toujours, au cours d'un processus itératif, sur la même unité de décodage.

Sur un autre plan, et toujours pour des messages courts, il est difficile d'utiliser la technique de la concaténation (typiquement un code en bloc BCH ou de Read-Solomon suivi, après entrelacement, d'un code convolutif) pour obtenir un fort pouvoir de correction : ou bien le code en bloc requiert une longueur de bloc supérieure à celle du message (cas du code de Read-Solomon), ou bien la taille de l'entrelacement est trop importante (cas du code BCH). L'on se contente donc aujourd'hui, soit d'un code convolutif avec bits de terminaison, soit d'un code en bloc, et donc d'un pouvoir de correction très moyen.

Des travaux ont déjà été menés sur des turbo-codes en bloc utilisant des codes BCH en tant que codes élémentaires. Ils sont notamment décrits dans l'article de R. Pyndiah, A. Glavieux, A. Picart and S. Jacq, "Near optimum decoding of product codes" in proc. of IEEE GLOBECOM '94, vol 1/3, pp. 339-343, Nov-Dec. 1994.

Les résultats sont excellents mais le schéma de codage présente des inconvénients : complexité du décodeur, peu de souplesse sur les rendements de codage, taille de blocs importante. Les turbo-codes en bloc convolutifs décrits dans la suite ont également d'excellentes performances, sont relativement simples à décoder et offrent une grande souplesse dans le choix des rendements de codage et des tailles de blocs.

L'invention a notamment pour objectif de pallier ces différents inconvénients de l'état de la technique.

Plus précisément, un objectif de l'invention est de fournir un procédé, et un dispositif correspondant, de codage convolutif qui présente les avantages des turbo-codes et qui est adapté au codage par blocs, ou messages.

Notamment, un objectif de l'invention est de fournir un tel procédé de codage, qui permette de "fermer" le code, de façon que chaque bloc soit traité indépendamment, à l'émission et à la réception, tout en assurant, bien sûr, un très fort pouvoir de correction.

Un autre objectif de l'invention est de fournir un tel procédé de décodage qui soit simple à mettre en oeuvre, sans nécessiter de moyens importants, et qui soit également simple à décoder.

L'invention a également pour objectif de pallier un tel procédé, qui n'impose aucune contrainte particulière sur la taille des blocs à traiter et notamment pas de taille minimale), et qui offre une grande souplesse dans le choix des rendements de codage.

Par ailleurs, l'invention a aussi pour objectif de fournir un procédé de décodage correspondant, qui soit simple et peu coûteux à mettre en oeuvre.

Un objectif de l'invention est de fournir un tel procédé de décodage, dont le fonctionnement puisse être adapté en fonction, par exemple, d'un taux d'erreurs maximal souhaité. Parallèlement, l'invention, a pour objectif de fournir un tel procédé de décodage, permettant de définir plusieurs types de récepteurs, en terme d'efficacité de correction d'erreurs, à partir d'un même codage.

Ces objectifs, ainsi que d'autres qui apparaîtront par la suite, sont atteint selon l'invention à l'aide d'un procédé de codage convolutif de blocs formés chacun d'un nombre N prédéterminé de données source, procédé selon lequel chacune desdites données source est introduite deux fois dans un même codeur convolutif mettant en oeuvre un polynôme générateur de période L, selon un ordre tel que les deux introductions d'une même donnée source $d_i$ sont séparées par l'introduction

de $(p_i.L)-1$ autres données source, $p_i$ étant un nombre entier non nul.

Cette technique de répétition systématique permet de garantir que le code soit fermé, comme cela est expliqué par la suite. En d'autres termes, l'état initial et l'état final du registre de codage sont parfaitement connus du décodeur, quelles que soient les données composant le message, ce qui permet d'initialiser le décodeur. Nulle donnée de terminaison n'est nécessaire pour fermer le code.

De nombreuses façons d'appliquer deux fois les données au codeur sont envisageables, dès lors qu'elles respectent la règle donnée ci-dessus.

Selon un mode de réalisation avantageux, qui donne des résultats efficaces, lesdites données source sont introduites dans ledit codeur une première fois (données dites originales) selon leur ordre naturel, puis une seconde fois (données dites dupliquées) selon un ordre tel que les deux introductions d'une même donnée source $d_i$ sont séparées par l'introduction de $(p_i.L)-1$ autres données source, $p_i$ étant un nombre entier non nul.

Cet ordre d'introduction desdites données dupliquées peut notamment être obtenu en :

- inscrivant les données source ligne à ligne dans une mémoire de taille $N = ni * n_c$, $n_1$ étant le nombre de lignes, multiple de L, et $n_c$ étant le nombre de colonnes, premier avec L ; et
- lisant lesdites données dupliquées colonne par colonne, en parcourant sur une colonne donnée, à l'instant $k_2$, les lignes successives jusqu'à ce qu'on trouve une donnée qui a été utilisée une première fois (donnée originale) à l'instant $k_1$ tel que $k_1-k_2$ soit multiple de L.

De façon préférentielle le codage selon l'invention est un codage systématique, lesdites données source étant systématiquement émises conjointement aux données délivrées par ledit codeur.

Cette technique s'avère particulièrement efficace, et permet de mettre en oeuvre la méthode de décodage itératif décrite par la suite.

De façon à améliorer le rendement du codage, le procédé de l'invention peut prévoir de mettre en oeuvre un poinçonnage des données délivrées par ledit codeur.

La taille des blocs considérés peut être qelconque. Selon un premier mode de réalisation, ce nombre N de données source formant un bloc est un multiple de la période L du polynôme générateur dudit codeur.

Selon un second mode de réalisation, lorsque le nombre N de données source formant un bloc n'étant pas un multiple de la période L du polynôme générateur dudit codeur, on complète chacun desdits blocs par un nombre N'-N de valeurs fixes, N' étant le multiple de L immédiatement supérieur à N.

Dans ce cas, lesdites valeurs fixes ne sont préférentiellement pas transmises et connues des récepteurs. Lesdites valeurs fixes peuvent être introduites :

- sous la forme d'un bloc, en début ou en fin de bloc ;
- régulièrement réparties parmi les données formant ledit bloc.

L'invention concerne également, bien sûr; les dispositifs mettant en oeuvre un tel procédé. Un tel dispositif comprend notamment des moyens pour introduire deux fois chacune desdites données source dans un même codeur convolutif mettant en oeuvre un polynôme générateur de période L, selon un ordre tel que les deux introductions d'une même donnée source $d_i$ sont séparées par l'introduction de $(p_i.L)-1$ autres données source, $p_i$ étant un nombre entier non nul.

Par ailleurs, l'invention concerne un procédé de décodage correspondant, comprenant une étape de décodage à maximum de vraisemblance tenant compte d'une part des données codées reçues, et d'autre part du fait que l'état initial et l'état final du codeur sont connus.

Préférentiellement, ledit codage étant un codage systématique, le procédé de décodage met en oeuvre une procédure itérative comprenant :

- duplication des symboles originaux reçus, et association à chacun d'eux de l'une ou l'autre des données de redondance reçus, de façon à former 2.N couples d'informations à décoder ;
- une première itération, comprenant les étapes suivantes :

    - initialisation du décodage, de façon à prendre en compte l'état initial du codeur;
    - détermination, pour chaque couple d'information, d'une estimation $s_k$ de celle-ci et d'une information extrinsèque $Z_k$ représentative de la confiance associée à ladite estimation, en fonction des données codées et des données de redondance reçues, et en tenant compte du fait que l'état initial et l'état final du codeur sont connus ;

- au moins une itération intermédiaire, répétant l'étape de détermination, en remplaçant les données source reçues par une combinaison pondérée des données source reçues et de l'information extrinsèque duale (c'est-à-dire relative à la donnée dupliquée) ;
- une dernière itération, délivrant une estimation définitive des données reçues, correspondant à la sommation de l'estimation obtenue à partir de l'un des symboles de redondance avec l'information extrinsèque obtenue à partir de l'autre symbole de redondance, pour chaque symbole source.

Cette technique permet de simplifier les décodeurs, et s'avère particulièrement efficace. Le nombre d'itérations est fonction de l'efficacité de décodage recherchée.

Avantageusement, une donnée de redondance est forcée à une valeur neutre, lorsque celle-ci a été supprimée par poinçonnage à l'émission.

De façon préférentielle, on applique une loi logarithmique sur la valeur absolue sur les estimations produites lors desdites étapes de détermination.

Cela permet d'empêcher qu'une erreur de poids élevé s'amplifie au cours du processus itératif.

Au moins deux modes de réalisation peuvent être envisagés. En effet, lesdites itérations sont mises en oeuvre en :

- réutilisant plusieurs fois un décodeur unique, à un rythme supérieur à celui des données transmises ;
- cascadant plusieurs modules de décodage, correspondant chacun à une itération.

Le premier cas correspond notamment aux applications à relativement faible débit, qui permettent que plusieurs itérations soient effectuées pendant la durée de transmission d'un bloc.

L'invention concerne également les décodeurs mettant en oeuvre ce procédé. Ils comprennent notamment des moyens de décodage à maximum de vraisemblance tenant compte d'une part des données codées reçues, et d'autre part du fait que l'état initial et l'état final du codeur sont connus.

D'autres caractéristiques et avantages de l'invention apparaîtront plus clairement à la lecture de la description suivante d'un mode de réalisation préférentiel de l'invention, donné à titre de simple exemple illustratif, et des dessins annexés, parmi lesquels :

- la figure 1 illustre, de façon schématique, la chaîne de transmission dans laquelle peuvent être mis en oeuvre les procédés de codage et décodage de l'invention ;
- la figure 2 présente un mode de mise en oeuvre du procédé de codage de l'invention, à l'aide d'une mémoire de taille 2N bits ;
- la figure 3 est une représentation simplifiée de la mise en oeuvre du procédé de l'invention, dans le cas où la première série de données est introduite dans l'ordre naturel ;
- la figure 4 est un simple exemple de codeur récursif systématique pouvant être utilisé selon l'invention ;
- la figure 5 illustre de façon générique un brasseur de polynôme G(D), discuté en annexe ;
- la figure 6 présente le principe de l'adressage de la mémoire de la figure 3 ;
- la figure 7 illustre le principe d'une itération du procédé de décodage de l'invention ;
- la figure 8 est un exemple de mise en oeuvre du procédé de décodage, dans le cas d'une structure séquentielle ;

- les figures 9A à 9E illustrent les résultats de décodage obtenus selon l'invention dans divers cas de figure, et en comparaison avec d'autres techniques de codage.

L'invention concerne donc les communications numériques. Elle propose une technique de codage et de décodage permettant une correction efficace des erreurs introduites par la transmission. Elle vise donc en particulier à améliorer la qualité des transmissions en présence d'éléments perturbateurs, tels que du bruit et/ou des brouilleurs.

Elle est particulièrement adaptée aux transmissions de messages courts. Elle trouve donc, par exemple, des applications dans les systèmes de radiocommunications avec les mobiles, ou dans les transmissions via satellites.

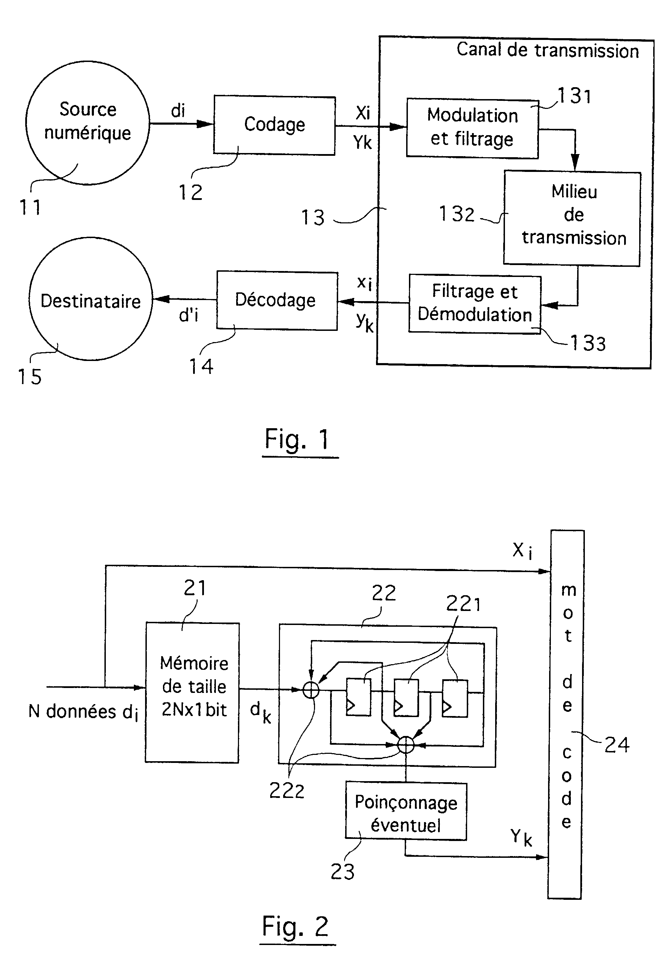

La chaîne de transmission, dans laquelle s'insèrent les procédés de l'invention, est illustrée en figure 1.

Les signaux à transmettre sont délivrés par une source numérique 11, sous la forme de messages (ou blocs) finis, comprenant chacun N données $d_i$. Les données $d_i$ peuvent correspondre à tout type de signal connu (numérique, ou analogique préalablement échantillonné). Le cas échéant, les messages finis peuvent bien sûr correspondre à des messages plus longs, voire continus, et découpés au format voulu.

Chaque message subit ensuite un codage 12, selon le procédé de l'invention, pour fournir des messages codés (ou paquets) comprenant T données codées (ou symboles). Dans le cas où un codage systématique est mis en oeuvre, ces symboles comprennent d'une part les données source $X_i$, et d'autre part des données de redondance $Y_k$.

Le message codé est ensuite transmis vers le destinataire, au travers du canal de transmission 13, qui induit différentes perturbations sur le signal. Le canal de transmission 13 peut être décomposé en trois éléments : la modulation et le filtrage 131 à l'émission, le milieu de transmission 132 proprement dit et le filtrage et la démodulation 133. Classiquement, les opérations 131 et/ou 133 comprennent notamment des procédés de lutte contre l'interférence entre symboles.

Les données reçues $x_i$ et $y_k$ alimentent le dispositif de décodage 14 mettant en oeuvre le procédé de l'invention, pour fournir un message estimé formé des données source estimées $d'_i$ au destinataire 15.

Le codage 14 peut par exemple être mis en oeuvre selon la structure illustrée en figure 2.

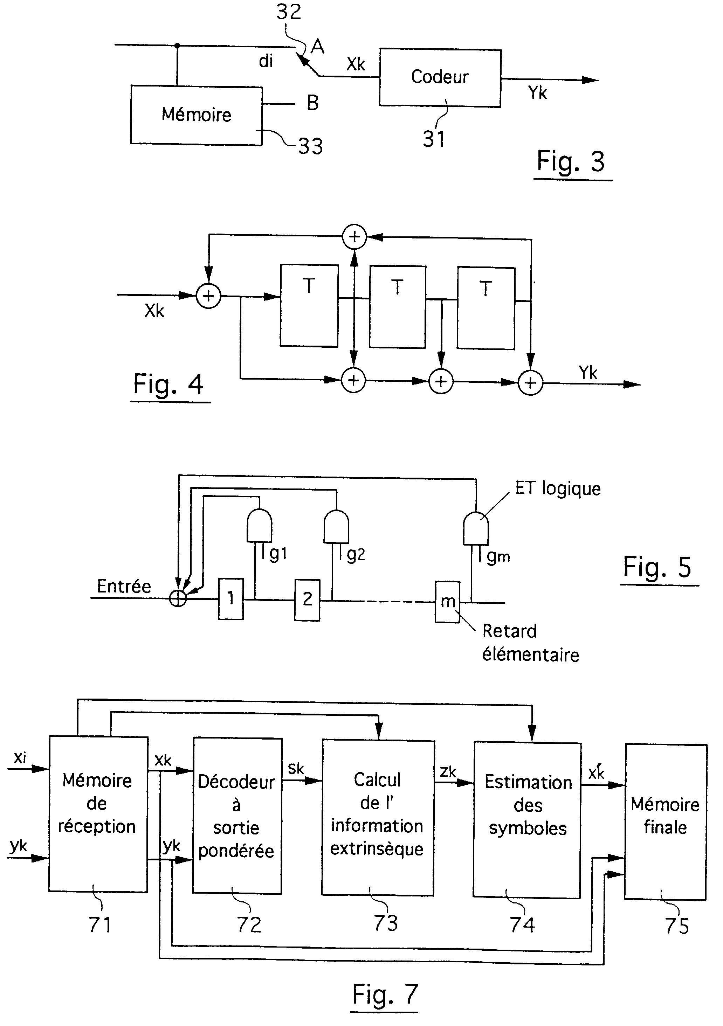

On considère que l'on désire coder des messages de N bits à l'aide d'un codeur systématique récursif (CSR) utilisant un polynôme générateur G(D) de longueur m et de période L. Un tel polynôme est illustré en figure 5, et commenté en annexe.

Selon l'invention, on choisit N (ou L) de façon qu'il soit un multiple de L, (on explique plus loin une méthode particulière lorsque ce n'est pas le cas), et on code chacune des N données source (bits) deux fois.

Pour cela, les N données $d_i$ sont copiées deux fois dans une mémoire 21 de taille 2N x 1 bit, à des adresses telles que leurs lectures ultérieures pour introduction dans le codeur 22 seront séparées d'un nombre de périodes multiple de L.

Ainsi, si $k_1(i)$ est l'instant de la première lecture d'une donnée particulière $d_i$ (donnée dite originale), alors l'instant $k_2(i)$ de la deuxième lecture (donnée dite dupliquée) vérifie la règle suivante :

$$k_2(i) = k_1(i) + p_i \cdot L \qquad (1)$$

En d'autres termes, la seconde lecture intervient $p_i \cdot L - 1$ instants après la première.

L'annexe jointe, qui fait partie intégrante de la présente description démontre que cette condition permet de vérifier que le codeur retrouvera systématiquement en fin de message l'état dans lequel il se trouvait en début de message.

Le codeur 22 est classiquement formé d'un jeu de retards élémentaires 221 et d'additionneurs 222. La figure 4 illustre un autre exemple de codeur convolutif récursif systématique.

Un tel codeur peut être assimilé à un générateur pseudo-aléatoire de période L. Par exemple, pour le codeur de la figure 3, la période L est de 7. Ainsi, en imaginant que le codeur de la figure 3 est initialisé dans un état 'tout 0' (c'est-à-dire que toutes les sorties des registres sont à 0) si une donnée non nulle lui est transmise, le signal de redondance sera périodique (réponse impulsionnelle périodique de longueur infinie). Par contre, si cette donnée est transmise une nouvelle fois au codeur après un temps multiple de la période L, le codeur reprendra son état initial. cette propriété est utilisée dans le procédé de codage.

Les données sont donc appliquées au codeur CSR 22 initialisé à l'état 0. Le codeur produit une redondance $Y_k$. La sortie du codeur est constituée par les symboles $X_i$ représentatifs des N données $d_i$ originales (c'est un code systématique) et la totalité ou partie de la redondance $Y_k$. Si toute la redondance est exploitée, le rendement de codage est 1/3. Pour obtenir des rendements supérieurs, un poinçonnage 23 de la redondance est nécessaire. Par exemple, pour obtenir un rendement de 1/2, $Y_k$ est transmis une fois sur 2.

Les $X_i$ et $Y_k$ forment le message codé, ou mot de code, 24, à transmettre.

Le code ainsi défini est un code en bloc car l'état initial et l'état final du registre de codage sont parfaitement connus (état 0). L'état final du codeur est bien 0 car il lui est appliqué N couples (donnée originale et donnée dupliquée) dans des conditions telles que la réponse (état final) du codeur à un couple est toujours 0 (c'est évident si la donnée originale est un "0" logique et la relation (1) l'assure si c'est un "1").

Le code étant linéaire, la réponse du codeur aux N couples est la somme des réponses à chacun des couples, et l'état final est toujours 0, quelles que soient les données composant le message. Les symboles reçus peuvent donc être décodés indépendamment de toute autre information, antérieure ou ultérieure, contrairement au cas du code convolutif classique. Nul bit de terminaison n'est nécessaire pour "fermer" le code.

De nombreuses façons d'appliquer deux fois au codeur sont envisageables. Une technique donnant de bons résultats est illustrée dans son principe en figure 3.

Les données à transmettre $d_i$ sont tout d'abord fournies au codeur 31 dans l'ordre naturel (sélecteur 32 en position A). Dans le même temps, elles sont stockées dans la mémoire 33. Les données dupliquées sont obtenues avec le sélecteur 32 en position B. L'ordre d'inscription et de lecture de la mémoire 33 doit bien sûr respecter la règle définie ci-dessus.

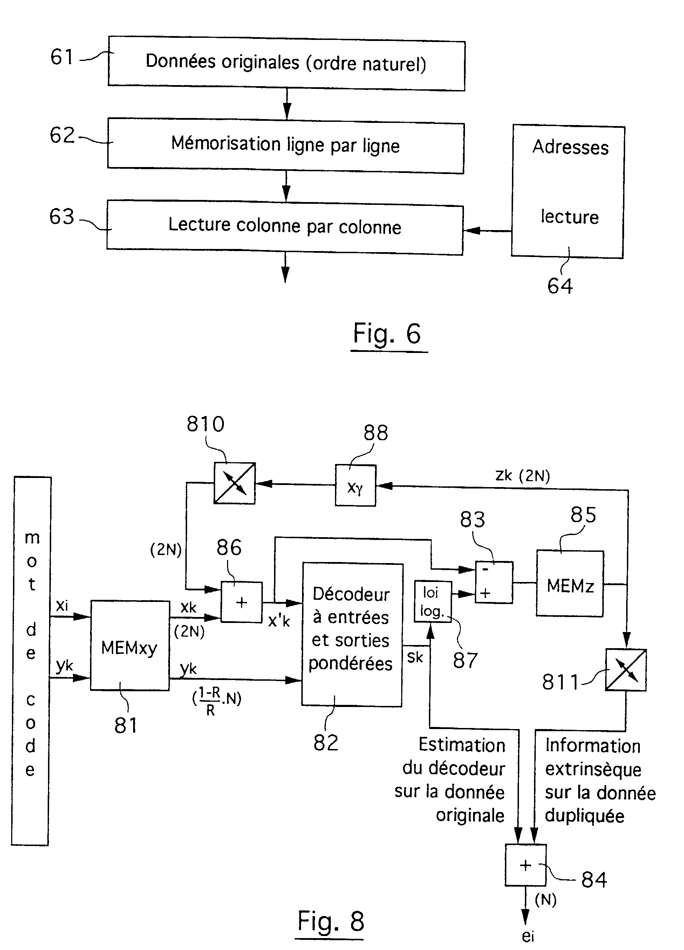

Cela peut par exemple se faire selon la méthode illustrée en figure 6, qui comprend les étapes suivantes :

- les données originales sont appliquées (61) dans leur ordre naturel au codeur ($k_1(i) = i$) ;
- dans le même temps, ces données sont mémorisées (62), ligne après ligne dans une mémoire de taille $n_1 \times n_c = N$. $n_1$ est le nombre de lignes, multiple de L et $n_c$ est le nombre de colonnes, premier avec L ;
- les données dupliquées sont lues (63) colonne par colonne, pour être appliquées au codeur, suivant un ordre qui satisfait la relation (1). C'est-à-dire qu'à l'instant $k_2$, on parcourt sur la colonne considérée les lignes successives jusqu'à ce que l'on trouve une donnée qui a été utilisée sous sa forme originale à l'instant $k_1$, tel que $k_2 - k_1$ soit multiple de L.

D'un point de vue pratique, ces adresses de lecture peuvent être mises en mémoire (ROM) 64 une fois pour toutes, pour pouvoir être également utilisées par le décodeur.

Le décodage est un processus itératif qui s'appuie sur le concept d'information extrinsèque introduit dans les documents décrivant les "turbo-codes", déjà cités en préambule de la présente demande. L'opérateur fondamental est un décodeur de code convolutif à entrées et sorties pondérées. Cela peut être le décodeur optimal (MAP) tel que décrit dans l'article de L. R. Bahl, J. Cocke, F. Jelinek and J. Raviv intitulé "Optimal decoding of linear codes for minimizing symbol error rate" (IEEE Trans. Inform. Theory, vol. IT-20, pp. 284-287, Mars 1974), ou un décodeur de Viterbi à sorties pondérées tel que présenté dans le document de brevet EP-92 460011.7 et dans l'article de C. Berrou et P. Adde, E. Angui et S. Faudeil "A low complexity soft-output Viterbi decoder architecture" (Proc. of IEEE ICC'93, Geneva, pp. 737-740, mai 1993).

La structure générale d'une itération du procédé de décodage est illustrée en figure 7.

Une mémoire de réception 71 stocke les données reçues ($x_i$; et $y_k$). Lorsque les données ne sont pas transmises (poinçonnage), elles sont remplacées par des valeurs neutres, c'est-à-dire des zéros analogiques. Un décodeur à sortie pondérée 72 est initialisé de telle sorte que l'état initial du codeur soit pris en compte.

L'ensemble des symboles $x_k$ et $y_k$ (ce sont les symboles $X_i$ et $Y_k$ émis par le codeur et altérés par le bruit), quantifiés sur q bits, est alors transmis au décodeur 72 qui fournit des symboles estimés des données associées à des informations de confiance. L'estimation de ces symboles et les calculs de la confiance sont faits en utilisant la propriété que l'état du codeur est connu en fin de paquet. L'association de la donnée estimée et de la confiance permet de calculer un symbole estimé sous un format équivalent à celui des symboles reçus. Ces symboles sont notés $s_k$. Il y a, donc, 2N symboles estimés.

Un calcul 73 de l'information extrinsèque $z_k$ est ensuite réalisé. Si le décodeur 72 est un décodeur de Viterbi, le calcul correspond aux opérations 83 et 87 de la figure 8, commentée par la suite.

On calcule donc $x'_k$, fonction pondérée de $x_k$ et $Z_k$ duale (relative à la donnée dupliquée).

Chaque symbole $x'_k$ est ensuite enregistré dans une mémoire appelée mémoire finale 75. Les symboles $x_k$ et $y_k$ sont transférés de la mémoire de réception à la mémoire finale sans traitement.

Dans la figure 7, la mémoire de réception 71 doit fournir les $X_{ri}$ et $Y_{rk}$ utiles au décodeur 72 ainsi que les $X_{ri}$ nécessaires aux calculs 73 de l'information extrinsèque et de l'estimation 74 des symboles. Il est sous-entendu que le système de la gestion de mémoire est intégré dans le bloc appelé mémoire de réception 71.

Deux structures d'implémentation du procédé de décodage peuvent être envisagées. La première est la structure de type pipe-line. Dans ce cas, il y a autant de décodeurs que d'itérations. La mémoire de réception est remplacée par la mémoire finale de l'itération précédente. Dans ce cas, ce sont les $x'_k$ qui sont transmis au décodeur 72. La dernière itération restitue les données estimées au destinataire. Ces données sont calculées comme étant la somme de la sortie $s_k$ relative à la donnée originale et de l'information extrinsèque duale $z_k$ duale (c'est-à-dire correspondant à la donnée dupliquée).

La seconde est une structure séquentielle, reposant sur l'utilisation répétée d'un unique décodeur. Elle est notamment bien adaptée aux communications à relativement bas débit, et permet de réaliser des décodeurs efficaces à faible coût de revient.

La figure 8 illustre un mode de mise en oeuvre de cette structure séquentielle.

Les symboles $x_i$ et $y_k$ issus du canal de transmission sont quantifiés sur q bits et rangés dans une mémoire MEMxy 81. Chaque donnée $x_i$ est mémorisée

deux fois, à des places identiques à celles qui ont servi au codage.

Dans une itération, le décodeur (MAP ou de Viterbi) 82 traite le bloc en 2.N périodes, à partir des informations x'k et $y_k$ Lorsqu'une donnée de redondance $y_k$ n'est pas disponible, s'il y a eu poinçonnage à l'émission, le décodeur est alimenté par une valeur neutre ou "zéro analogique".

Les itérations se succèdent "à la volée", c'est-à-dire que le décodeur est alimenté sans interruption, les données relatives à l'itération p étant contiguës à celles relatives à l'itération p - 1. au début du traitement, puis ensuite toutes les 2.N périodes, le décodeur est forcé à l'état 0 (la métrique cumulée de l'état 0 est annulée et les autres métriques cumulées sont fixées à une forte valeur). Le traitement s'arrête à l'itération préprogrammée.

A la sortie du décodeur 82 deux types d'information sont élaborées à chaque itération : l'information extrinsèque $z_k$ et l'estimation $e_i$ relative à la donnée $d_i$ codée.

Chaque étape du processus itératif produit 2.N informations extrinsèques et N estimations.

Dans le cas où le décodeur 82 est un décodeur de Viterbi, l'information extrinsèque est simplement calculée comme la différence 83 entre la sortie pondérée $s_k$, compressée par une loi logarithmique 87, et l'entrée $x'_k$ (le décodeur étant supposé sans latence pour simplifier). L'estimation $e_i$ est, elle, calculée comme la somme 84 de la sortie $s_k$ relative à la donnée originale et de l'information extrinsèque $Z_k$ duale (relative à la donnée dupliquée). Les informations extrinsèques sont rangées dans une mémoire MEMz 85.

L'entrée $x'_k$ du décodeur relative à la donnée d est formée par la somme 86 du symbole $x_k$ et de l'information extrinsèque $z_k$ duale élaborée à l'itération précédente, pondérée 88 par le coefficient γ (à la première itération, la mémoire MEMz 85 est remplie par des valeurs neutres).

C'est-à-dire que si $x_k$ est le symbole dont la place dans le codage correspond à la donnée originale, on lui rajoute l'information extrinsèque relative à la donnée dupliquée, et inversement. C'est cet échange croisé d'informations qui assure, au fil des itérations, la décroissance du taux d'erreurs sur la sortie estimée du décodeur.

Les éléments 810 et 811 assurent la transposition entre la donnée originale et la donnée dupliquée, aux instants voulus.

La performance du turbo-code en bloc convolutif est d'autant meilleure que N est élevé. Pour de faibles valeurs de N, c'est la corrélation des bruits affectant les informations $x_k$ et $z_k$ qui sont additionnées à l'entrée du décodeur, qui limite le pouvoir de correction du code. On conçoit en effet aisément que si ces deux estimations d'une même donnée sont erronées, la diversité inhérente au turbo-décodage s'en trouve forcément réduit. Une réponse à ce problème est donnée par la loi logarithmique 87 dont les effets sont d'empêcher une erreur de poids élevé de s'amplifier au cours du processus itératif. La loi logarithmique porte sur la valeur absolue et est de la forme :

$$Y = \theta.\log (1 + x/\theta)$$

où θ est une constante choisie de manière empirique. Le double de la valeur absolue des symboles $x_k$ non bruités semble être une bonne valeur pour θ.

Le coefficient de pondération γ est fixé à une valeur inférieure à l'unité et est ajusté selon le rendement de codage (γ est d'autant plus faible que le rendement est bas).

Le turbo-code en bloc convolutif, tel que décrit ci-dessus, est construit autour de blocs d'information dont la longueur N est multiple de la période L du générateur pseudo-aléatoire.

Une manière simple de traiter des blocs de longueur N' quelconque est de retenir une valeur de N multiple de L, immédiatement supérieure à N' et de compléter les N' données à coder par N - N' valeurs binaires connues, par exemple N - N' '0'. Evidemment, ces '0' ne sont pas transmis car la partie réceptrice connaît le nombre et la position de ces '0' d'appoint.

Une autre façon de procéder pour obtenir ces blocs dont la longueur est multiple de 4 (cas pratique courant) quand la période du générateur est de 5 (cas du polynôme 37) est la suivante : le codeur, toutes les 5 périodes, est alimenté par un '0', et corrélativement, le décodeur, toutes les 5 périodes, est forcé à une transition correspondant à une donnée '0'. On a alors N' = (4.N)/5. L'insertion des '0' d'appoint ne requiert pas nécessairement de périodes supplémentaires de traitement car, pour le codeur comme pour le décodeur, l'insertion d'un '0' peut être combinée (anticipée) avec l'insertion de la donnée le précédant.

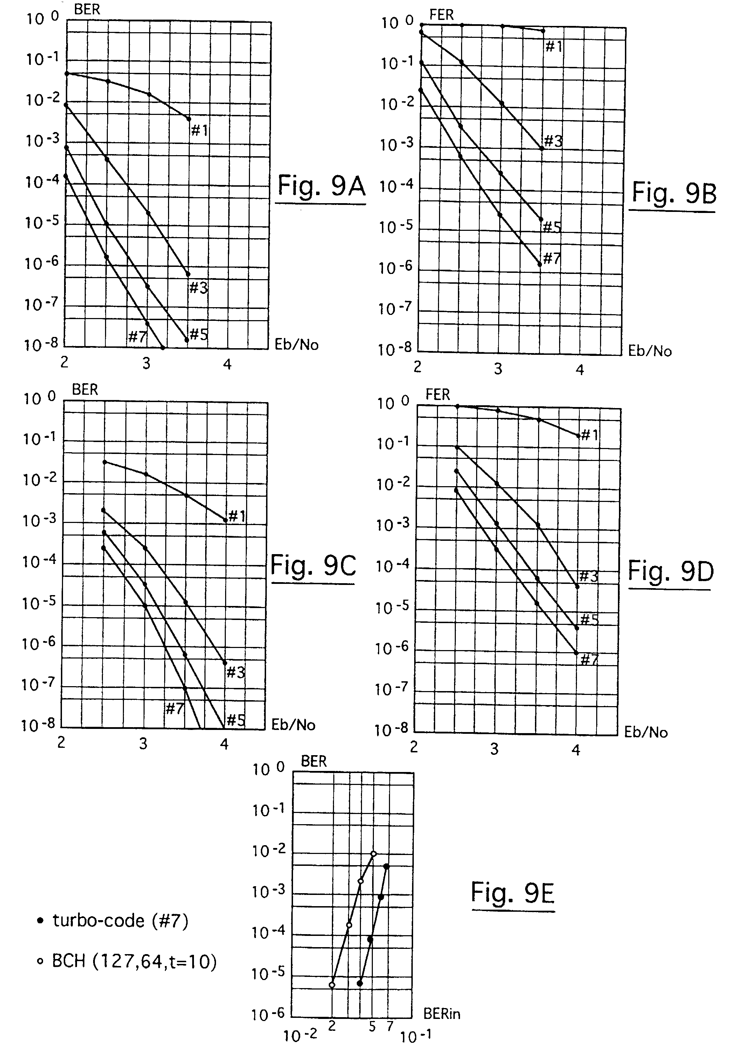

On présente en figures 9A à 9E quelques résultats de simulation obtenus, à l'issue des itérations 1, 3, 5 et 7, dans les trois cas suivants :

- figures 9A et 9B : taux d'erreur binaire (BER) et taux d'erreur de trame (FER) avec N = 880 bits, R = 1/2, entrées x et y quantifiées sur 4 bits ;
- figures 9C et 9D : taux binaire et taux d'erreur de trame avec N = 220 bits, R = 1/2, entrées x et y quantifiées sur 4 bits ;
- figure 9E : comparaison avec le code BCH (127,64) lorsque N = 220 bits, R = 1/2, entrées x et y quantifiées sur 1 bit (décodage à décision ferme).

L'abscisse représente, soit le rapport signal à bruit Eb/No, soit le taux d'erreurs binaires en entrée du décodeur $BER_{in}$ (BER: Binary Error Rate). L'ordonnée porte soit le taux d'erreurs binaires BER en sortie du décodeur, soit le taux d'erreurs de trames FER en sortie du décodeur (FER : Frame Error Rate).

Dans les trois simulations, le polynôme du générateur pseudo-aléatoire est 37 (période L = 5), le polynôme générateur de la redondance est 25. Le décodeur élémentaire utilise l'algorithme de Viterbi modifié déjà mentionné. Le cas de la figure 9E est comparé au code BCH (127,64) de rendement très proche de 1/2 et dont le pouvoir de correction est t = 10 (voir l'article "procédé de décodage d'un code convolutif à maximum de vraisemblance et pondération des décisions, et décodeur correspondant" déjà cité).

Cette comparaison, bien que portant sur des blocs d'information de longueurs différentes, montre clairement que le code proposé, décodé en décision ferme, est plus performant que le code BCH, avec une complexité de décodage bien plus faible (dans sa version séquentielle). L'écart est encore plus marqué, bien sûr, si le turbo-décodeur fonctionne en décisions fines.

**ANNEXE**

Un codeur CSR est bâti autour d'un brasseur *("scrambler")*, lui-même déduit d'un générateur pseudo-aléatoire, de longueur de mémoire *m*. Le polynôme du générateur est noté

$$G(D) = 1 + \sum_{j=1}^{m} g_j . D^j$$

(figure 5), *D* étant la variable symbolique de retard *("Delay")*. La longueur *L* de la sequence pseudo-aléatoire du générateur est donnée par la plus petite valeur possible du degré *r* du polynôme particulier $P(D) = 1 + D^r$ multiple de $G(D)$. Par exemple, si $G(D) = 1 + D + D^2 + D^3 + D^4$, le premier polynôme $P(D)$ multiple de $G(D)$ est $1 + D^5$. La longueur de la séquence est donc 5. On peut montrer que $L$ est dans tous les cas inférieure ou égale à $2^m - 1$.

**Théorème 1:**

Si $G(D)$ divise $1 + D^L$, alors $G(D)$ divise $1 + D^{L.p}$, $\forall p$ entier $\geq 1$.
<u>Preuve :</u> La série arithmétique

$$\sum_{k=0}^{p-1} A^k$$

vérifie dans l'algèbre classique :

$$\sum_{k=0}^{p-1} A^k = \frac{1 - A^p}{1 - A}$$

et dans l'algèbre binaire :

$$\sum_{k=0}^{p-1} A^k = \frac{1 + A^p}{1 + A}$$

$1 + A^p$ est donc multiple de $1 + A$, et pour $A = D^L$, $1 + D^{L.p}$ est multiple de $1 + D^L$. Donc, Si $G(D)$ divise $1 + D^L$, $G(D)$ divise aussi $1 + D^{L.p}$.

Dire qu'un polynôme $P(D)$ est multiple de $G(D)$ signifie en pratique que si la séquence binaire associée à $P(D)$ est appliquée au codeur, à partir de l'état 0, celui-ci retrouvera l'état 0 à l'issue de la séquence.

***Exemple :***

Soit $G(D) = 1 + D + D^2 + D^3 + D^4$. $G(D)$ divise $1 + D^5$. La séquence 100001 fait quitter l'état 0 du codeur à l'arrivée du premier '1' et l'y fait retourner à l'arrivée du second '1'. D'après le théorème 1, il en est de même pour toute séquence 100..001 où les deux '1' sont séparés par 5.$p$ - 1 '0', $\forall p$ entier $\geq 1$.

**Revendications**

1.  Procédé de codage convolutif de blocs formés chacun d'un nombre N prédéterminé de données source ($d_i$),
    caractérisé en ce que chacune desdites données source ($d_i$) est introduite deux fois dans un même codeur convolutif (22 ; 31) mettant en oeuvre un polynôme générateur de période L, selon un ordre tel que les deux introductions d'une même donnée source $d_i$ sont séparées par l'introduction de ($p_i$.L)-1 autres données source, $p_i$ étant un nombre entier non nul.

2.  Procédé de codage selon la revendication 1, caractérisé en ce que lesdites données source sont introduites dans ledit codeur une première fois (données dites originales) (A) selon leur ordre naturel, puis une seconde fois (données dites dupliquées) (B) selon un ordre tel que les deux introductions d'une même donnée source $d_i$ sont séparées par l'introduction de ($p_i$.L)-1 autres données source, $p_i$ étant un nombre entier non nul.

3.  Procédé de codage selon la revendication 2, caractérisé en ce que l'ordre d'introduction desdites données dupliquées est obtenu en :

    -   inscrivant (62) les données source ligne à ligne dans une mémoire (21 ; 33) de taille N = ni * $n_c$, $n_1$ étant le nombre de lignes, multiple de L, et $n_c$ étant le nombre de colonnes, premier avec L ; et
    -   lisant (63) lesdites données dupliquées colonne par colonne, en parcourant sur une colonne donnée, à l'instant $k_2$, les lignes successives jusqu'à ce qu'on trouve une donnée qui a été utilisée une première fois (donnée originale) à l'instant $k_1$ tel que $k_1 - k_2$ soit multiple de L.

4. Procédé de codage selon l'une quelconque des revendications 1 à 3, caractérisé en ce qu'il s'agit d'un codage systématique, lesdites données source étant systématiquement émises conjointement aux données délivrées par ledit codeur.

5. Procédé de codage selon l'une quelconque des revendications 1 à 4, caractérisé en ce qu'il met en oeuvre un poinçonnage (23) des données délivrées par ledit codeur.

6. Procédé selon l'une quelconque des revendications 1 à 5, caractérisé en ce que le nombre N de données source formant un bloc est un multiple de la période L du polynôme générateur dudit codeur.

7. Procédé selon l'une quelconque des revendications 1 à 5, caractérisé en ce que, le nombre N de données source formant un bloc n'étant pas un multiple de la période L du polynôme générateur dudit codeur, on complète chacun desdits blocs par un nombre N'-N de valeurs fixes, N' étant le multiple de L immédiatement supérieur à N.

8. Dispositif de codage convolutif de blocs formés chacun d'un nombre N prédéterminé de données source,
caractérisé en ce qu'il comprend des moyens (21 ; 32, 33) pour introduire deux fois chacune desdites données source dans un même codeur convolutif (22 ; 31) mettant en oeuvre un polynôme générateur de période L, selon un ordre tel que les deux introductions d'une même donnée source $d_i$ sont séparées par l'introduction de $(p_i.L)-1$ autres données source, $p_i$ étant un nombre entier non nul.

9. Procédé de décodage d'un bloc codé formé de données codées, correspondant à un bloc source formé d'un nombre N prédéterminé de données source,
caractérisé en ce que ledit bloc source a subi un codage tel que chacune desdites données source a été introduite deux fois dans un même codeur convolutif mettant en oeuvre un polynôme générateur de période L, selon un ordre tel que les deux introductions d'une même donnée source $d_i$ sont séparées par l'introduction de $(p_i.L)-1$ autres données source, $p_i$ étant un nombre entier non nul,
et en ce qu'il comprend une étape (72 ; 82) de décodage à maximum de vraisemblance tenant compte d'une part des données codées reçues, et d'autre part du fait que l'état initial et l'état final du codeur sont connus.

10. Procédé de décodage selon la revendication 9, caractérisé en ce que, ledit codage étant un codage systématique, il met en oeuvre une procédure itérative comprenant :

- duplication des symboles originaux reçus, et association à chacun d'eux de l'une ou l'autre des données de redondance reçus, de façon à former 2.N couples d'informations à décoder ;
- une première itération, comprenant les étapes suivantes :

  - initialisation du décodage, de façon à prendre en compte l'état initial du codeur ;
  - détermination, pour chaque couple d'information, d'une estimation $s_k$ de celle-ci et d'une information extrinsèque $z_k$ représentative de la confiance associée à ladite estimation, en fonction des données codées et des données de redondance reçues, et en tenant compte du fait que l'état initial et l'état final du codeur sont connus ;

- au moins une itération intermédiaire, répétant l'étape de détermination, en remplaçant les données source reçues par une combinaison pondérée des données source reçues et de l'information extrinsèque duale ;
- une dernière itération, délivrant une estimation définitive des données reçues, correspondant à la sommation (84) de l'estimation obtenue à partir de l'un des symboles de redondance avec l'information extrinsèque obtenue à partir de l'autre symbole de redondance, pour chaque symbole source.

11. Procédé selon la revendication 10, caractérisé en ce qu'on applique une loi logarithmique (87) sur la valeur absolue sur les estimations produites lors desdites étapes de détermination.

12. Procédé selon l'une quelconque des revendications 10 et 11, caractérisé en ce que lesdites itérations sont mises en oeuvre en :

- réutilisant plusieurs fois un décodeur unique, à un rythme supérieur à celui des données transmises :
- cascadant plusieurs modules de décodage, correspondant chacun à une itération.

13. Décodeur d'un bloc codé formé de données codées, correspondant à un bloc source formé d'un nombre N prédéterminé de données source,
caractérisé en ce que ledit bloc source a subi un codage tel que chacune desdites données source a été introduite deux fois dans un même codeur convolutif mettant en oeuvre un polynôme générateur de période L, selon un ordre tel que les deux introductions d'une même donnée source $d_i$ sont séparées par l'introduction de $(p_i \cdot L)-1$ autres données source, $p_i$ étant un nombre entier non nul, et en ce que ledit décodeur comprend des moyens (72 ; 82) de décodage à maximum de vraisemblance tenant compte d'une part des données codées reçues, et d'autre part du fait que l'état initial et l'état final du codeur sont connus.

**Patentansprüche**

1. Verfahren zur Faltungskodierung von Blöcken, die jeweils aus einer vorgegebenen Zahl N von Quelldaten ($d_i$) gebildet sind, dadurch gekennzeichnet, daß jede dieser Quelldaten ($d_i$) zweimal in eine Faltungskodiervorrichtung (22; 31) eingegeben wird, welche ein Erzeugerpolynom mit der Periode L gemäß einer derartigen Reihenfolge anwendet, daß die zwei Eingaben des gleichen Quelldatenwertes $d_i$ durch die Eingabe von $(p_i \cdot L)-1$ weiteren Quelldaten getrennt sind, wobei $p_i$ eine ganze, von Null verschiedene Zahl ist.

2. Kodierverfahren gemäß Anspruch 1, dadurch gekennzeichnet, daß die Quelldaten in die Kodiervorrichtung ein erstes Mal (sogenannte Ursprungsdaten) (A) in ihrer natürlichen Reihenfolge eingegeben werden und ein zweites Mal (sogenannte duplizierte Daten) (B) in einer solchen Reihenfolge eingegeben werden, daß die zwei Eingaben des gleichen Quelldatenwertes $d_i$ durch die Eingabe von $(p_i \cdot L)-1$ weiteren Quelldaten getrennt sind, wobei $p_i$ eine ganze, von Null verschiedene Zahl ist.

3. Kodierverfahren gemäß Anspruch 2, dadurch gekennzeichnet, daß die Reihenfolge der Eingabe der duplizierten Daten durch die folgenden Schritte erzielt wird:

   - Schreiben (62) der Quelldaten Zeile für Zeile in einen Speicher (21; 33) der Größe $N = n_1 * n_c$, wobei $n_1$ die Zahl der Zeilen, die ein Vielfaches von L ist und $n_c$ die Zahl der Spalten darstellt, wobei $n_c$ und L keine gemeinsame Teiler haben und
   - Lesen (63) dieser duplizierten Daten Spalte um Spalte, wobei in einer gegebenen Spalte zum Zeitpunkt $k_2$ die aufeinanderfolgenden Zeilen durchlaufen werden, bis ein Datenwert gefunden wird, der ein erstes Mal (Ursprungsdatenwert) zum Zeitpunkt $k_1$ angewandt wurde, wobei $k_1 - k_2$ ein Vielfaches von L ist.

4. Kodierverfahren gemäß einem der Ansprüche 1 bis 3,

dadurch gekennzeichnet, daß es sich dabei um eine systematische Kodierung handelt, wobei die Quelldaten systematisch zusammen mit den von der Kodiervorrichtung gelieferten Daten gesendet werden.

5. Kodierverfahren gemäß einem der Ansprüche 1 bis 4,
dadurch gekennzeichnet, daß es eine Markierung (23) der von der Kodiervorrichtung gelieferten Daten anwendet.

6. Verfahren gemäß einem der Ansprüche 1 bis 5, dadurch gekennzeichnet, daß die Zahl N der Quelldaten, die einen Block bilden, ein Vielfaches der Periode L des Erzeugerpolynoms dieser Kodiervorrichtung ist.

7. Verfahren gemäß einem der Ansprüche 1 bis 5, dadurch gekennzeichnet, daß angesichts der Tatsache, daß die Zahl N der Quelldaten, die einen Block bilden, kein Vielfaches der Periode L des Erzeugerpolynoms dieser Kodiervorrichtung ist, jeder dieser Blöcke durch eine Zahl N' - N fester Werte vervollständigt wird, wobei N' das Vielfache von L ist, welches unmittelbar größer als N ist.

8. Vorrichtung zur Faltungskodierung von Blöcken, die jeweils aus einer vorgegebenen Zahl N von Quelldaten gebildet werden, dadurch gekennzeichnet, daß sie Mittel (21; 32, 33) umfaßt, um jeden dieser Quelldatenwerte zweimal in dieselbe Faltungskodiervorrichtung (22; 31) einzugeben, die einen Erzeugerpolynom mit der Periode L anwendet, in einer solchen Reihenfolge, daß die zwei Eingaben eines gleichen Quelldatenwertes $d_i$ durch die Eingabe von $(p_i \cdot L)-1$ weiteren Quelldaten getrennt sind, wobei $p_i$ eine ganze, von Null verschiedene Zahl ist.

9. Verfahren zum Dekodieren eines aus kodierten Daten gebildeten Blocks, der einem Quellblock entspricht, welcher aus einer vorgegebenen Zahl N von Quelldaten gebildet wird, dadurch gekennzeichnet, daß der Quellblock einer derartigen Kodierung unterworfen wurde, daß jeder der Quelldatenwerte zweimal in dieselbe Faltungskodiervorrichtung eingegeben wurde, die ein Erzeugerpolynom mit der Periode L anwendet, in einer solchen Reihenfolge, daß die zwei Eingaben des gleichen Quelldatenwertes $d_i$ durch die Eingabe von $(p_i \cdot L)-1$ weiteren Quelldaten getrennt sind, wobei $p_i$ eine ganze, von Null verschiedene Zahl ist und, daß es einen Dekodierschritt (72; 82) mit höchster Wahrscheinlichkeit umfaßt, der einerseits die empfangenen kodierten Daten und andererseits die Tatsache berücksichtigt, daß der Ausgangszustand und der Endzustand der Kodiervorrichtung bekannt sind.

10. Verfahren zum Dekodieren gemäß Anspruch 9, dadurch gekennzeichnet, daß es, weil es sich bei der Kodierung um eine systematische Kodierung handelt, eine iterative Prozedur anwendet, die folgendes umfaßt:

- Duplizieren der empfangenen Ursprungssymbole und Zuordnen zu jedem dieser Symbole des einen oder des anderen empfangenen Redundanzdatenwertes, um so 2·N Paare von Informationen zu bilden, die dekodiert werden müssen;
- wobei eine erste Iteration die folgenden Schritte umfaßt:

    - Initialisierung der Dekodierung, um den Ausgangszustand der Kodiervorrichtung zu berücksichtigen;
    - Feststellung für jedes Paar von Informationen einer Schätzung $s_k$ dieses Paares und einer äußerlichen Information $z_k$, die repräsentativ ist für das Vertrauen, welches der Schätzung entgegengebracht wird, als Funktion der kodierten Daten und der empfangenen Redundanzdaten sowie unter Berücksichtigung der Tatsache, daß der Ausgangszustand und der Endzustand der Kodiervorrichtung bekannt sind;

- mindestens eine Zwischeniteration, die den Feststellungsschritt dadurch wiederholt, daß die empfangenen Quelldaten durch eine gewichtete Kombination der empfangenen Quelldaten und der äußerlichen dualen Information ersetzt werden;
- eine letzte Iteration, die für jedes Quellsymbol eine endgültige Abschätzung der empfangenen Daten liefert, welche der Addition (84) der ausgehend von einem der Redundanzsymbolen erzielten Abschätzung mit der ausgehend vom anderen Redundanzsymbol erzielten äußerlichen Information entspricht.

11. Verfahren gemäß Anspruch 10, dadurch gekennzeichnet, daß ein logarithmisches Gesetz (87) auf den Absolutwert der bei den Feststellungsschritten erzielten Abschätzungen angewandt wird.

12. Verfahren gemäß einem der Ansprüche 10 oder 11, dadurch gekennzeichnet, daß die Iterationen folgendermaßen angewandt werden:

- durch mehrfache Wiederverwendung eines Einzeldecoders mit einem höheren Rhythmus als der der gesendeten Daten;
- durch Kaskadieren von mehreren Dekodiermodulen, die jeweils einer Iteration entsprechen.

13. Dekodiervorrichtung für einen aus kodierten Daten gebildeten kodierten Block, der einem aus einer vorgegebenen Zahl N von Quelldaten gebildeten Quellblock entspricht, dadurch gekennzeichnet, daß der Quellblock einer derartigen Kodierung unterworfen wurde, daß jede der Quelldaten zweimal in eine Faltungskodiervorrichtung eingegeben wurde, die ein Erzeugerpolynom mit der Periode L gemäß einer derartigen Reihenfolge anwendet, daß die zwei Eingaben des gleichen Quelldatenwertes $d_i$ durch die Eingabe von $(p_i . L)-1$ weiteren Quelldaten getrennt sind, wobei $p_i$ eine ganze, von Null verschiedene Zahl ist und, daß diese Dekodiervorrichtung Mittel (72; 82) zum Dekodieren mit höchster Wahrscheinlichkeit umfaßt, die einerseits die empfangenen kodierten Daten und andererseits die Tatsache berücksichtigen, daß der Ausgangszustand und der Endzustand der Kodiervorrichtung bekannt sind.

**Claims**

1. Method for convolutional coding of blocks, each made up of a predetermined number N of source data ($d_i$), characterised in that each of the said source data ($d_i$) is introduced twice into a given convolutional encoder (22; 31) implementing a generating polynomial of period L in a sequence such that the two introductions of a given source data element $d_i$ are separated by the introduction of $(p_i.L)-1$ other source data, $p_i$ being an integer other than zero.

2. Coding method according to Claim 1, characterised in that the said source data are introduced into the said encoder a first time (data termed original data) (A) in their natural sequence, then a second time (data termed duplicated data) (B) in a sequence such that the two introductions of a given source data element $d_i$ are separated by the introduction of $(p_i.L)-1$ other source data, $p_i$ being an integer other than zero.

3. Coding method according to Claim 2, characterised in that the sequence of introduction of the said duplicated data is obtained by:

- recording (62) the source data row by row in a memory (21; 33) of size $N = n_r*n_c$, $n_r$ being the number of rows, which is a multiple of L, and $n_c$ being the number of columns, which is a prime number with L; and

- reading (63) the said duplicated data column by column, passing in a given column, at point in time $k_2$, through successive rows until a data element is found which has been used a first time (original data) at the point in time $k_1$ such that $k_1$-$k_2$ is a multiple of L.

4. Coding method according to any one of Claims 1 to 3, characterised in that said coding is systematic coding, the said source data being systematically transmitted in conjunction with the data supplied by the said encoder.

5. Coding method according to any one of Claims 1 to 4, characterised in that it uses punching (23) of the data supplied by the said encoder.

6. Method according to any one of Claims 1 to 5, characterised in that the number N of source data making up a block is a multiple of the period L of the generating polynomial of the said encoder.

7. Method according to any one of Claims 1 to 5, characterised in that when the number N of source data making up a block is not a multiple of the period L of the generating polynomial of the said encoder, each of the said blocks is supplemented by a number N'-N of fixed values, N' being the multiple of L immediately greater than N.

8. Device for convolutional coding of blocks each made up of a predetermined number N of source data,
characterised in that it comprises means (21;, 32, 33) for introducing each of the said source data twice into a given convolutional encoder (22; 31) implementing a generating polynomial of period L in a sequence such that the two introductions of a given source data element $d_i$ are separated by the introduction of $(p_i.L)$-1 other source data, $p_i$ being an integer other than zero.

9. Method for decoding an encoded block made up of coded data, corresponding to a source block made up of a predetermined number N of source data, characterised in that the said source block has been subjected to encoding such that each of the said source data has been introduced twice into a given convolutional encoder implementing a generating polynomial of period L in a sequence such that the two introductions of a given source data element $d_i$ are separated by the introduction of $(p_i.L)$-1 other source data, $p_i$ being an integer other than zero, and in that it comprises a maximum probability decoding step (72; 82) taking account, on the one hand, of the encoded data received and, on the other hand, of the fact that the initial state and the final state of the encoder are known.

10. Decoding method according to Claim 9, characterised in that as the said encoding is systematic encoding it implements an iterative procedure comprising:

- duplication of the original symbols received and association with each of these of one or the other of the redundancy data received so as to form 2.N pairs of information to be decoded;
- a first iteration, comprising the following steps:

  - initialisation of the decoding so as to take account of the initial state of the encoder;
  - determination, for each information pair, of an estimate $s_k$ of the latter and of an extrinsic information element $z_k$ representative of the confidence associated with the said estimate, as a function of the encoded data and the redundancy data received, and taking account of the fact that the initial state and the final state of the encoder are known;

- at least one intermediate iteration, repeating the determination step, replacing the source data received by a weighted combination of the source data received and the dual extrinsic information;
- a final iteration, producing a definitive estimate of the data received, corresponding to the summing (84) of the estimate obtained on the basis of one of the redundancy symbols and the extrinsic information obtained on the basis of the other redundancy symbol, for each source symbol.

11. Method according to Claim 10, characterised in that a logarithmic law (87) is applied to the absolute value on the estimates produced during the said determination steps.

12. Method according to either one of Claims 10 and 11, characterised in that the said iterations are implemented by:

- reusing a single decoder several times at a rhythm higher than that of the transmitted data;
- cascading several decoding modules, each corresponding to one iteration.

13. Decoder for an encoded block made up of encoded data, corresponding to a source block made up of a predetermined number N of source data, characterised in that the said source block has been subjected to encoding such that each of the said source data has been introduced twice into a given convolutional encoder implementing a generating polynomial of period L in a sequence such that the two introductions of a given source data element $d_i$ are separated by the introduction of $(p_i.L)-1$ other source data, $p_i$ being an integer other than zero, and in that the said decoder comprises maximum probability decoding means (72; 82) taking account, on the one hand, of the encoded data received and, on the other hand, of the fact that the initial state and the final state of the encoder are known.

Canal de transmission

Source
numérique

di

Codage

Xi
Yk

Modulation
et filtrage

131

Milieu
de
transmission

132

13

Destinataire

d'i

Décodage

xi
yk

Filtrage et
Démodulation

133

11

12

15

14

## Fig. 1

Xi

m
o
t

d
e

c
o
d
e

21

22

221

Mémoire
de taille
2Nx1bit

N données di

dk

⊕

222

Poinçonnage
éventuel

23

Yk

24

## Fig. 2

32

A

di

Xk

Codeur

Yk

Mémoire

B

33

31

Fig. 3

Xk

T   T   T

Yk

Fig. 4

ET logique

g1   g2   gm

Entrée

1   2   m

Retard
élémentaire

Fig. 5

xi

Mémoire
de
réception

xk

Décodeur
à
sortie
pondérée

Sk

Calcul
de l'
information
extrinsèque

zk

Estimation
des
symboles

x̂k

Mémoire
finale

yk

yk

71   72   73   74   75

Fig. 7

61 — Données originales (ordre naturel)

62 — Mémorisation ligne par ligne

63 — Lecture colonne par colonne

Adresses

lecture

64

## Fig. 6

810

88

$x\gamma$

zk (2N)

m
o
t

d
e

c
o
d
e

(2N)

86

(2N)

xi

xk

MEMxy

(2N)

yk

yk

$(\frac{1-R}{R}.N)$

81

x'k

+

Décodeur
à entrées
et sorties
pondérées

sk

82

loi
log.

87

83

−
+

85

MEMz

811

Estimation
du décodeur
sur la donnée
originale

Information
extrinsèque
sur la donnée
dupliquée

+

84

(N)

ei

## Fig. 8

Fig. 9A

Fig. 9B

Fig. 9C

Fig. 9D

Fig. 9E

• turbo-code (#7)

○ BCH (127,64,t=10)